# EUROPÄISCHE PATENTSCHRIFT

(11) **EP 2 075 871 B1**
(45) Veröffentlichungstag und Bekanntmachung des Hinweises auf die Patenterteilung: **13.02.2013**
(21) Anmeldenummer: 08021333.3
(22) Anmeldetag: 09.12.2008
(51) Int. Cl.: H01M 10/48, G01R 31/36

(54) **Verfahren zur Identifikation und Qualitätsdokumentation von Akkumulatoren sowie Akkumulator für Industriewerkzeuge**
method of identification and quality documentation of accumulators and accumulators for industrial tools
Méthode pour l'identification et la documentation de qualité d'accumulateurs ainsi qu'accumulateurs pour utils industriels

(30) Priorität: 17.12.2007 DE 102007061171; 25.11.2008 DE 102008058924
(43) Veröffentlichungstag der Anmeldung: 01.07.2009
(73) Patentinhaber: Zielke, Guido, 9871 Seeboden (AT)
(72) Erfinder: Zielke, Guido, 9871 Seeboden (AT)
(74) Vertreter: Döpp, Ludger

(56) Entgegenhaltungen:
- DE-A1- 19 547 019
- US-A1- 2006 083 955
- US-A1- 2007 188 131

## Beschreibung

Die Erfindung betrifft ein Verfahren zur Identifikation und Qualitätsdokumentation von Akkumulatoren für Industriewerkzeuge.

Industriewerkzeuge sind beispielsweise Schrauber, wie sie vielfach in der Automobilindustrie eingesetzt werden.

Alle namhaften Hersteller von Elektrowerkzeugen bieten heute für ihre Akkumulatoren in der Regel eine eigene Ladetechnik an. Fast immer sind dies Tischgeräte, deren Aufnahme speziell auf die Geometrie und Leistungsdaten der jeweiligen Hersteller abgeglichen sind. Akkumulatoren des Herstellers "A" können somit nicht mit Ladegeräten des Herstellers "B" geladen werden. Das Ergebnis ist eine große Anzahl von Einzelladegeräten. Eine Addition des Energieverbrauchs aller Ladegeräte ergibt einen unverhältnismäßig hohen Gesamtenergieverbrauch.

Neben Akkumulatoren für Handwerkzeuge, wie sie beispielsweise in Privathaushalten zum Einsatz gelangen, sind gerade Akkumulatoren in der Industrie unersetzlich. Ähnlich wie in Privathaushalten werden auch für Industrieanwendungen für spezielle Werkzeuge unterschiedliche Akkumulatoren eingesetzt, die zwar in großen Mengen in der Industrie vorhanden sind, wobei jedoch die Qualitätssicherung der einzelnen Akkumulatoren nie gegeben ist. Weder eine eindeutige Identifizierung von Akkumulatoren noch deren durchgängige Dokumentation sind üblich. So geschieht es, dass Akkumulatoren, die beispielsweise in der Automobilindustrie eingesetzt werden, lediglich mit einer Produktnummer versehen werden, wobei es für die Handhabung durch unterschiedliche Personen, die den Akkumulator dann einsetzen wollen, schwierig ist festzustellen, inwieweit er aufgeladen oder einer Reparaturmaßnahme/einem Aufladevorgang zuzuführen ist. In gleicher Weise wird die Vielzahl der unterschiedlichen Aufladegeräte für die praktische Handhabung als ungeeignet angesehen.

Eine derartige Dokumentation ist für Privathaushalte eher nicht notwendig, da die dort eingesetzten Akkumulatoren in der Regel von gleichen Personen benutzt werden, die mit dem Zustand ihres Akkumulators vertraut sind.

Der DE 20 2004 012 366 U1 ist eine Einrichtung für die Identifizierung von Parametern elektrisch auf- und entladbarer Speicher zu entnehmen, wobei der Speicher mit einem nicht flüchtigen Informationsspeicherbaustein gekoppelt ist, der über eine Datenverbindung mit einem Informationslesegerät in einem Ladegerät verbunden ist. Der Informationsspeicherbaustein ist auf den elektrisch auf- und entladbaren Speicher aufgeklebt. Alternativ besteht auch die Möglichkeit, dass der Informationsspeicherbaustein in eine den elektrisch auf- und entladbaren Speicher umgebenden Schutzfolie eingeschweißt ist. Als Datenverbindung kommen zusätzliche elektrische Leitungen zum Einsatz, so dass ein erhöhter Aufwand betrieben werden muss.

In der DE 299 18 369 U1 wird ein Akkumulatorladegerät beschrieben, mit mindestens einer Ladebucht für einen Akkumulator sowie Lese- und Schreibmittel, die mit einer Controllereinheit zur Steuerung und/oder Regelung eines Akkumulatorladevorgangs verbunden sind, wobei die Lese- und/oder Schreibmittel zum Zugriff auf die Daten eines Informationsträgers ausgelegt sind, der am Akkumulator angeordnet ist. Die Lese- und/oder Schreibmittel sind zur kontaktlosen Abfrage von Daten vom Informationsträger ausgestaltet, die in einem über eine elektronische Schaltung ansprechbaren Datenspeicher abgelegt sind. Der Informationsträger ist hierbei als Transponder ausgebildet. Transponder haben den Nachteil, dass sie maximal 4 KB Datenspeicher haben, eine eigene Energieversorgung benötigen und eine langsame Lese- und Schreibgeschwindigkeit haben.

Ziel des Erfindungsgegenstandes ist es, ein Verfahren zur Identifikation und Qualitätsdokumentation von Akkumulatoren, ausschließlich für Industriewerkzeuge über deren Standzeit, bereitzustellen, das ohne Verwendung zusätzlicher Datenleitungen einfach in der Anwendung ist und das auch erlaubt, eine Vielzahl unterschiedlicher Akkumulatoren mit gleichen technischen Kriterien zu überprüfen.

Darüber hinaus soll eine Möglichkeit geschaffen werden, einem jeden Akkumulator eine individuelle Erkennungskomponente hinzuzufügen, die ihn jederzeit individuell identifizierbar macht sowie über seine Standzeit begleitet.

Dieses Ziel wird einerseits erreicht durch ein Verfahren zur Identifikation und Qualitätsdokumentation von für Industriewerkzeuge einsetzbaren Akkumulatoren, indem der jeweilige Akkumulator dergestalt mit mindestens einer elektronischen Schaltung bestückt wird, dass mindestens ein Bauteil der Schaltung an der jeweiligen Zelle des Akkumulators angeschlossen ist, bei der ersten Implementierung oder bei der Herstellung des Akkumulators vorgebbare Stammdaten in einen Speicherbaustein der elektronischen Schaltung geschrieben werden und im Zuge von weiteren Aufladungen und/oder Reparaturen des Akkumulators der Speicherbaustein zumindest mit Betriebsdaten, die im Verlauf des jeweiligen Ladezyklus bzw. Reparaturvorgangs ermittelt wurden, beschrieben wird.

Vorteilhafte Weiterbildungen des erfindungsgemäßen Verfahrens sind den zugehörigen verfahrensgemäßen Unteransprüchen zu entnehmen.

Die im jeweiligen Akkumulator integrierte elektronische Schaltung ermittelt somit eigenständig alle relevanten Prozessparameter und hält selbige im Speicherbaustein vor.

Das erlaubt auch den Ladebetrieb mit nicht intelligenten Ladestationen. Kommen über diverse Ladezyklen derartige Ladestationen zum Einsatz, wird beim Auslesen aller Daten auch die bisherige Historie bereitgehalten.

Dieses Ziel wird auch erreicht durch einen Akkumulator für Industriewerkzeuge, der mit mindestens einer, zumindest einen Speicherbaustein aufweisenden elektronischen Schaltung dergestalt bestückt ist, dass zumindest ein Bauteil der elektronischen Schaltung innerhalb des Akkumulatorgehäuses an die jeweilige Zelle des Akkumulators angeschlossen ist.

Vorteilhafte Weiterbildungen des erfindungsgemäßen Akkumulators sind den zugehörigen gegenständlichen Unteransprüchen zu entnehmen.

Die elektronische Schaltung ist als Platine ausgebildet und beinhaltet zumindest einen Speicherbaustein, wobei bei der Herstellung des Akkumulators mindestens ein Bauteil der Platine, beispielsweise eine als Mikrocontroller ausgebildete Messelektronik, fest mit der/den Zelle(n) des Akkumulators in Wirkverbindung gebracht wird. Jeder Lade-/Entladevorgang wird somit mit der Zeit dokumentiert und im Speicherbaustein der elektronischen Schaltung abgelegt. Der Ladezustand, bedarfsweise auch die Temperatur, des Akkumulators werden bedarfsweise von dem Mikrocontroller ebenfalls überwacht.

Bei der erstmaligen Implementation / bei der Herstellung des Akkumulators werden definierte Stammdaten in den Speicherbaustein geschrieben. Selbige bestehen aus bestimmten Merkmalen, wie beispielsweise
- Seriennummer,
- Kunde,
- Akkutyp,
- Zellenspannung,
- Kapazität,
- Datum der Lieferung oder dergleichen.

Jedes Mal, wenn der gleiche Akkumulator zwecks Ladung oder Reparatur in eine Ladestation eingebracht wird, werden bedarfsweise die im Speicherbaustein vorhandenen Stammdaten ausgelesen. Im Anschluss an den Ladevorgang, respektive die Reparatur, werden an den Akkumulator, respektive an den Speicherbaustein der elektronischen Schaltung, alle relevanten Daten (zumindest die Betriebsdaten) übertragen, die im Verlauf des jeweiligen Ladezyklus/der jeweiligen Reparatur ermittelt wurden bzw. entstanden sind. Betriebsdaten sind beispielsweise:
- Anfangszellenspannung vor der Ladung,
- Zellenspannung nach der Ladung,
- Datum, Uhrzeit und Dauer der Ladung,
- Temperatur/Ladestromverlauf
- zugeführte Leistung,
- Prüfperson oder dergleichen.,
- Ladekurve (graphisch),
- Ladespannungsverlauf,
- Anzahl der bisher erfolgten Ladezyklen.
   Bildlich gesprochen wird somit in Analogie zu einem PC ein Speicherbereich hoher Kapazität geschaffen und alle relevanten Daten sind stets innerhalb des jeweiligen Akkumulators vorhanden.
   Wird dieses Verfahren über die Zeit regelmäßig angewendet, entsteht für einen jeden Akkumulator automatisch ein lückenloser Lebenslaufnachweis.
   Der Fachmann wird abhängig vom Einsatzbereich des jeweiligen Akkumulators die Anzahl der relevanten Stamm- und Betriebsdaten festlegen.
   Würde bei einem Akkumulator lediglich die Seriennummer gespeichert werden, müsste in einer Rechnereinheit eine Datenbank vorgehalten werden, die alle anfallenden Daten enthält. Damit kann der jeweilige Akkumulator nur innerhalb derselben Rechnereinheit verwaltet werden, an der auch das Ladegerät angeschlossen ist.
   Speichert man hingegen die gesamte Historie im Akkumulator selbst ab, besteht dieses Problem nicht mehr. Mit dem Erfindungsgegenstand kann somit ein national/international gültiger Standard definiert werden.
   Dies wird insbesondere erreicht durch
- die Verwendung von elektronischen Schaltungen, die einen großen Speicher haben,
- durch Softwarealgorithmen, die bedarfsweise in verschlüsselter Form alle Daten in den Speicherbaustein der elektronischen Schaltung des Akkumulators schreiben,
- durch Softwaremechanismen, die Daten in kombinierter Form bedarfsweise mittels Kennungen ablegen.

Wie bereits eingangs ausgesprochen, werden in der Industrie für einzelne Anwendungen unterschiedlich gestaltete und vielfach mit unterschiedlichen Kapazitäten/Nennspannungen versehene Akkumulatoren vorgehalten, wobei es in der Regel für jeden einzelnen Akkumulator einer separaten Ladestation bedarf. Das Vorhalten derartiger Ladestationen ist für den täglichen Einsatz in der Industrie unpraktisch und darüber hinaus unwirtschaftlich.

Es ist deshalb auch Teil des vorliegenden Erfindungsgegenstandes, im Bereich einer einzelnen Ladestation verschiedene Adapter für unterschiedlich ausgebildete Akkumulatoren vorzusehen, so dass sämtliche unterschiedlich ausgestalteten Akkumulatoren im Wesentlichen simultan geprüft und geladen werden können. Ein jeder Adapter passt somit zu einem zugehörigen Akkumulator. Hier ist lediglich ein einmaliger Aufwand von Nöten, um eine Vielzahl von unterschiedlichen Akkumulatoren innerhalb einer einzelnen die Adapter aufzunehmenden Ladestation zu prüfen und aufzuladen. Von besonderem Vorteil ist, dass im Bereich der Adapter elektronische Baugruppen vorgesehen und untereinander vorteilhafterweise über eine einzelne Datenbusleitung verbunden werden, wobei eine einzelne Datenleitung zur Rechnereinheit, beispielsweise einem PC, hergestellt wird. Die Rechnereinheit verfügt vorteilhafterweise über eine Akkumulatordatenbank, im Bereich derer aus dem Speicherbaustein der elektronischen Schaltung ausgelesene Daten sowie in den Speicherbaustein einzuschreibende Daten verwaltet werden können.

Bei Verwendung von Adaptern im Bereich einer einzelnen gemeinsamen Ladestation kann je nach Energiegehalt des zu ladenden Akkumulators der Stromverbrauch der Ladestation in einen Stand-By-Modus geschaltet und somit der Stromverbrauch auf wenige mA reduziert werden.

Der Erfindungsgegenstand ist anhand eines Ausführungsbeispiels in der Zeichnung dargestellt und wird wie folgt beschrieben. Es zeigen:
- Figur 1: Prinzipskizze eines Akkumulators, beinhaltend eine elektronische Schaltung;
- Figur 2: Prinzipskizze einer elektronischen Schaltung für einen Akkumulator gemäß Figur 1;
- Figur 3: Prinzipskizze einer Ladestation für unterschiedliche Akkumulatoren.

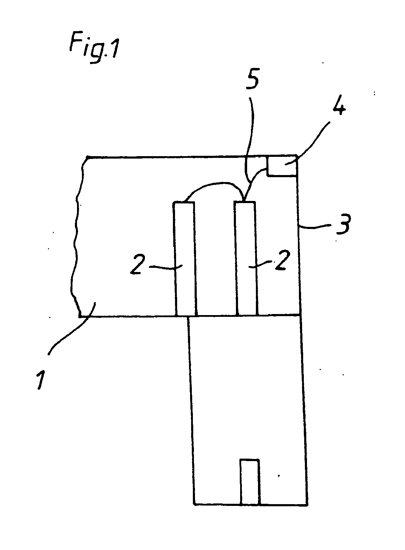

Figur 1 zeigt als Prinzipskizze einen Akkumulator 1, der mit nur angedeuteten Zellen 2 versehen ist. Innerhalb des Gehäuses 3 ist eine elektronische Schaltung 4 vorgesehen, die über Leitungen 5 an die Zellen 2 angeschlossen ist. Diese elektronische Schaltung 4 wird hierbei bei der Produktion des Akkumulators 1 mit in das Gehäuse 3 eingebaut, ist sozusagen integraler Bestandteil des Akkumulators 1. Der Aufbau der elektronischen Schaltung 4 wird in der folgenden Figur näher beschrieben.

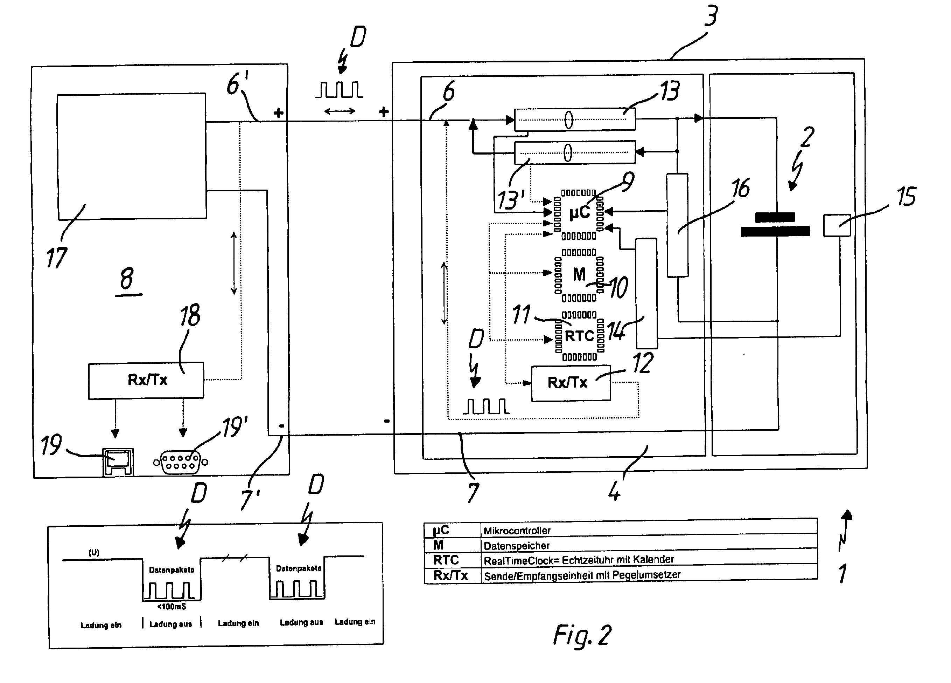

Figur 2 zeigt als Prinzipskizze den Aufbau einer elektronischen Schaltung 4 für einen Akkumulator 1. Der besseren Übersicht halber ist lediglich eine einzelne Zelle 2 dargestellt. Der Akkumulator 1 besitzt zwei Pole 6,7 (Plus und Minus), über welche er mit einem Ladegerät 8 in Wirkverbindung bringbar ist. Die Pole 6,7 sind in diesem Beispiel als Leitungen dargestellt. Die als Platine ausgebildete elektronische Schaltung 4 beinhaltet in diesem Beispiel einen, eine Messelektronik bildenden, Mikrocontroller 9, einen Speicherbaustein 10, eine Echtzeituhr mit Kalender 11 sowie eine Sende-/Empfangseinheit 12. Des Weiteren ist ein Stromwandler 13 für den Ladestrom sowie ein Stromwandler 13' für den Entladestrom, ein Messverstärker 14 für einen Temperatursensor 15 sowie ein Messverstärker 16 für die Akkuspannung auf der elektronischen Schaltung 4 vorgesehen. Der Mikrocontroller 9 misst unter anderem den Lade- und den Entladestrom, den Spannungsabfall U im Bereich der Zelle 2. In dem Speicherbaustein 10 sind bei der erstmaligen Implementierung / Herstellung des Akkumulators 1 Stammdaten, wie beispielsweise die Seriennummer des Akkumulators 1, der Kunde, der Akkutyp, die Zellenspannung, die Kapazität und bedarfsweise auch das Datum der Lieferung geschrieben worden. Es wird in diesem Beispiel vorausgesetzt, dass der Akkumulator 1 für einen ersten Einsatz geladen wurde, so dass im Speicherbaustein 10 lediglich die Stammdaten enthalten sind.

In diesem Beispiel soll der Akkumulator 1 für einen weiteren Einsatzbereich neu aufgeladen werden. Er wird über die Pole 6,7 mit entsprechenden Gegenpolen 6',7' des Ladegerätes 8 in Wirkverbindung gebracht. Das in diesem Beispiel intelligente Ladegerät 8 kann bedarfsweise mit einem Display 17 ausgerüstet werden, auf welchem beispielsweise die Ladekurve des Akkumulators 1 bei der Neuaufladung der Zelle 2 abgebildet werden kann. Das Ladegerät 8 verfügt ebenfalls, wie die elektronische Schaltung 4, über eine Sende-/Empfangseinheit 18 sowie mindestens eine Schnittstelle 19,19', über die es mit einer nicht dargestellten Rechnereinheit verbindbar ist. Die Bauteile 17,18,19,19' sind hierbei Elemente, die nicht zwangsläufig im Bereich des Ladegerätes 8 vorgesehen sein müssen.

Ebenfalls denkbar ist, vom Akkumulator 1 ausgehende (nicht dargestellt) Schnittstellen vorzusehen, so dass der Akkumulator 1 unmittelbar mit einer nachgeschalteten Rechnereinheit (nicht dargestellt) verbunden werden kann. Im Bereich der Zelle 2 des Akkumulators 1 ist in diesem Beispiel noch der Temperatursensor 15 vorgesehen, der die zellenseitige Temperatur misst und als weiteren Parameter über den Messverstärker 14 an den Mikrocontroller 9 weiterleitet. Im Verlauf des Ladevorganges werden nun die im Speicherbaustein 10 vorhandenen Stammdaten, gegebenenfalls in Verbindung mit den Temperaturdaten der Zelle 2, über den Pol 6 des Akkumulators 1 sowie 6' des Ladegerätes 8 aus dem Speicherbaustein 10 ausgelesen. Hier bieten sich alternativ folgende Möglichkeiten an:
- die Daten D werden aufmoduliert (oberes Bild);
- die Daten D werden während Auslastlücken zum Lade-/Lesegerät 8 übertragen (unteres Bild).

Dies gilt bidirektional sowohl vom Speicherbaustein 10 zum nachgeschalteten Medium, z.B. dem Ladegerät 8 als auch umgekehrt.

Die jeweilige Art der Datenübertragung wird der Fachmann von Fall zu Fall festlegen. Im Verlauf des Ladevorganges oder nach dem Ladevorgang werden dem Speicherbaustein 10 über die Pole 6',6,7',7 neben den Stammdaten weitere Daten zugeführt, die als Betriebsdaten definiert werden. Selbige können z. B. wie folgt angegeben werden: Anfangszellenspannung vor der Ladung; Zellenspannung nach der Ladung; Datum, Uhrzeit und Dauer der Ladung; Temperatur-/Lade-Stromverlauf; zugeführte Leistung; Prüfperson oder dergleichen sowie die Ladekurve des Akkumulators 8.

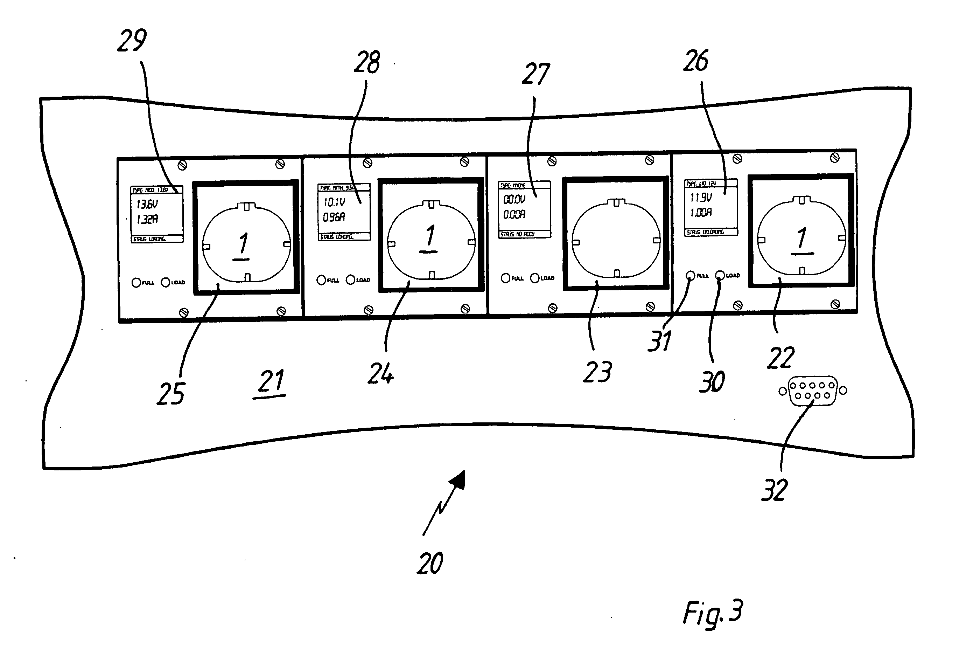

Figur 3 zeigt als Prinzipskizze eine Ladestation 20 für unterschiedliche Akkumulatoren 1. Erkennbar ist ein Grundgehäuse 21, das in diesem Beispiel mit vier Ladeeinschüben 22,23,24,25 (Adaptern) versehen ist. Einem jedem Ladeeinschub 22 bis 25 ist ein TFT-Display 26,27,28,29 zugeordnet. In diesem Beispiel sollen die Ladeeinschübe 22,24 und 25 mit Akkumulatoren 1 versehen sein, während der Ladeeinschub 23 keinen Akkumulator aufweist. Die in den Einschüben 22 und 24 vorgesehenen, nicht näher dargestellten Akkumulatoren 1 werden geladen, während der im Einschub 25 vorgesehene Akkumulator 1 entladen wird. Die entsprechenden Anzeigen werden auf dem zugehörigen Display 26 bis 29 abgebildet. Über entsprechende LED-Zustandsanzeigen 30,31 wird der jeweilige Betriebszustand des jeweiligen Akkumulators 1 angezeigt. Am Grundgehäuse 21 kann eine Schnittstelle 32 vorgesehen sein, die über ein Datenkabel mit einer nicht dargestellten Rechnereinheit in Wirkverbindung steht.

Wird dieses Verfahren regelmäßig, d.h. bei allen Ladungen/Reparaturen angewendet, entsteht automatisch für einen jeden Akkumulator 1 über seine Standzeit eine individuelle lückenlose Dokumentation.

Der Erfindungsgegenstand ist ausschließlich auf Akkumulatoren anwendbar, die in der Industrie einsetzbar sind, da hier ein großes Potential hinsichtlich eindeutiger Identifizierung von Akkumulatoren in Kombination mit einer durchgängigen Dokumentation gegeben ist.

Somit wird die gesamte Historie eines jeden Akkumulators direkt auf dem damit in Wirkverbindung stehenden Speicherbaustein 10 der elektronischen Schaltung 4 abgespeichert.

### Bezugszeichenliste

- 1: Akkumulator
- 2: Zelle
- 3: Gehäuse
- 4: elektronische Schaltung
- 5: Leitung
- 6: Pol/Leitung
- 6': Pol/Leitung
- 7: Pol/Leitung
- 7': Pol/Leitung
- 8: Ladegerät
- 9: Mikrocontroller (Messelektronik)
- 10: Speicherbaustein
- 11: Echtzeituhr
- 12: Sende-/Empfangseinheit
- 13: Stromwandler
- 13': Stromwandler
- 14: Messverstärker
- 15: Temperatursensor
- 16: Messverstärker
- 17: Display
- 18: Sende-/Empfangseinheit
- 19: Schnittstelle
- 19': Schnittstelle
- 20: Ladestation
- 21: Grundgehäuse
- 22: Ladeeinschub/Adapter
- 23: Ladeeinschub/Adapter
- 24: Ladeeinschub/Adapter
- 25: Ladeeinschub/Adapter
- 26: Display
- 27: Display
- 28: Display
- 29: Display
- 30: LED-Zustandsanzeige
- 31: LED-Zustandsanzeige
- 32: Schnittstelle
- D: Daten

## Patentansprüche

1. Verfahren zur Identifikation und Qualitätsdokumentation von für Industriewerkzeuge einsetzbaren Akkumulatoren (1), indem der jeweilige Akkumulator (1) dergestalt mit mindestens einer elektronischen Schaltung (4) bestückt wird, dass mindestens ein Bauteil (9) der Schaltung (4) an der jeweiligen Zelle (2) des Akkumulators (1) angeschlossen ist, bei der ersten Implementierung oder bei der Herstellung des Akkumulators (1) vorgebbare Stammdaten in einen Speicherbaustein (10) der elektronischen Schaltung (4) geschrieben werden und im Zuge von weiteren Aufladungen und/oder Reparaturen des Akkumulators (1) der Speicherbaustein (10) zumindest mit Betriebsdaten, die im Verlauf des jeweiligen Ladezyklus bzw. Reparaturvorgangs ermittelt wurden, beschrieben wird.

2. Verfahren nach Anspruch 1, **dadurch gekennzeichnet, dass** die Stammdaten im Verlauf eines Ladezyklus bzw. eines Reparaturvorgangs aus dem Speicherbaustein (10) ausgelesen werden, wobei im Anschluss an den Ladevorgang bzw. die Reparatur des Akkumulators (1) zumindest Betriebsdaten, die im Verlauf des Lade- bzw. Reparaturvorgangs ermittelt wurden, in den Speicherbaustein (10) geschrieben werden.

3. Verfahren nach Anspruch 1 oder 2, **dadurch gekennzeichnet, dass** die jeweiligen Daten (D) über im Bereich des Akkumulators (1) vorhandene Leitungen/Pole (6,7) aus dem Speicherbaustein (10) der elektronischen Schaltung (4) ausgelesen und auch über die Leitungen/Pole (6,7) in den Speicherbaustein (10) geschrieben werden.

4. Verfahren nach einem der Ansprüche 1 bis 3, **dadurch gekennzeichnet, dass** die Daten (D) über die Plus- (6) und Minusleitung (7) des Akkumulators (1) aus dem Speicherbaustein (10) ausgelesen und auch darüber in den Speicherbaustein (10) geschrieben werden.

5. Verfahren nach einem der Ansprüche 1 bis 3, **dadurch gekennzeichnet, dass** die Daten (D) über die Leitung eines Temperatursensors (15) und die Minusleitung (7) des Akkumulators (1) aus dem Speicherbaustein (10) ausgelesen und auch darüber in den Speicherbaustein (10) geschrieben werden.

6. Verfahren nach einem der Ansprüche 1 bis 5, **dadurch gekennzeichnet, dass** die Daten (D) über das Ladegerät (8) des Akkumulators (1) und/oder eine Rechnereinheit aus dem Speicherbaustein (10) ausgelesen und auch darüber in den Speicherbaustein (10) geschrieben werden.

7. Verfahren nach einem der Ansprüche 1 bis 6, **dadurch gekennzeichnet, dass** die jeweiligen Daten (D) in verschlüsselter Form aus dem Speicherbaustein (10) ausgelesen bzw. darauf geschrieben werden.

8. Verfahren nach einem der Ansprüche 1 bis 7, **dadurch gekennzeichnet, dass** der jeweilige Lade-/Entladevorgang des Akkumulators (1) mit der Zeit datenmäßig dokumentiert und im Speicherbaustein (10) abgelegt wird.

9. Verfahren nach einem der Ansprüche 1 bis 8, **dadurch gekennzeichnet, dass** der Lade-/Entladevorgang in Form eines, gegebenenfalls an einem Display (17) der Ladestation (8) anzeigbaren graphischen Kurve dokumentiert wird.

10. Verfahren nach einem der Ansprüche 1 bis 9, **dadurch gekennzeichnet, dass** die Ladestation (8) des Akkumulators (1) mit einer Rechnereinheit verbunden wird, wobei alle relevanten Daten (D) bedarfsweise aus dem Speicherbaustein (10) ausgelesen, über das Ladegerät (8) ausgegeben und zur Rechnereinheit übertragen werden sowie nach erfolgtem Ladevorgang bzw. nach erfolgter Reparatur des Akkumulators (1) in umgekehrter Reihenfolge wieder in den Speicherbaustein (10) geschrieben werden, so dass ein jeder Akkumulator (1) stets mit seiner gesamten Historie, über seine Standzeit gesehen, ausgestattet ist.

11. Verfahren nach einem der Ansprüche 1 bis 10, **dadurch gekennzeichnet, dass** im Speicherbaustein (10) eine dem Akkumulator (1) zuzuordnende Seriennummer abgelegt wird, über welche der mit der elektronischen Schaltung (4) ausgerüstete Akkumulator (1) unzweideutig erkennbar ist.

12. Verfahren nach einem der Ansprüche 1 bis 10, **dadurch gekennzeichnet, dass** zur gleichzeitigen Aufladung unterschiedlicher Akkumulatoren (1) diese in passende Adapter (22,23,24,25) eingeführt und im Bereich einer gemeinsamen Ladestation (20) simultan geprüft und aufgeladen werden.

13. Verfahren nach einem der Ansprüche 1 bis 12, **dadurch gekennzeichnet, dass** im Bereich der Adapter (22 bis 25) elektronische Baugruppen vorgesehen und untereinander über eine Datenbusleitung verbunden werden, wobei eine einzelne Datenleitung von der Ladestation (20) zur Rechnereinheit hergestellt wird.

14. Verfahren nach einem der Ansprüche 1 bis 13, **dadurch gekennzeichnet, dass** die Rechnereinheit über eine Datenbank verfügt, im Bereich derer die Stammdaten und die jeweiligen Betriebsdaten eines jeden zu prüfenden/aufzuladenden Akkumulators (1) hinterlegt werden.

15. Verfahren nach einem der Ansprüche 1 bis 14, **dadurch gekennzeichnet, dass** die Daten (D) der jeweiligen Stromleitung (6,7) des Akkumulators (1) aufmoduliert werden.

16. Verfahren nach einem der Ansprüche 1 bis 14, **dadurch gekennzeichnet, dass** zum Auslesen/Schreiben der Daten (D) die Stromversorgung des Akkumulators (1) in vorgebbaren Zeitintervallen abgeschaltet und in dieser Zeit die jeweiligen Daten (D) paketweise übertragen werden.

17. Akkumulator für Industriewerkzeuge, der mit mindestens einer, zumindest einen Speicherbaustein (10) aufweisenden elektronischen Schaltung (4) dergestalt bestückt ist, dass die elektronische Schaltung (4) innerhalb des Akkumulatorgehäuses (3) an die jeweilige Zelle (2) des Akkumulators (1) angeschlossen ist.

18. Akkumulator nach Anspruch 17, **dadurch gekennzeichnet, dass** die elektronische Schaltung (4) zumindest eine Messelektronik (9), einen Speicherbaustein (10) und eine Sende-/Empfangseinheit (12) beinhaltet.

19. Akkumulator nach Anspruch 17 oder 18, **dadurch gekennzeichnet, dass** die elektronische Schaltung (4) eine Echtzeituhr (11) mit Kalender beinhaltet.

20. Akkumulator nach einem der Ansprüche 17 bis 19, **dadurch gekennzeichnet, dass** die jeweiligen Daten (D) über im Bereich des Akkumulators (1) vorhandene Leitungen/Pole (6,7) aus dem Speicherbaustein (10) auslesbar, bzw. in den Speicherbaustein (10) schreibbar sind.

21. Akkumulator nach einem der Ansprüche 17 bis 20, **dadurch gekennzeichnet, dass** die als Mikrocontroller ausgebildete Messelektronik (9) mit der jeweiligen Zelle (2) des Akkumulators (1) in Wirkverbindung steht.

22. Akkumulator nach einem der Ansprüche 17 bis 21, **dadurch gekennzeichnet, dass** die Sende-/Empfangseinheit (12) der elektronischen Schaltung (4) mit einer gleichartigen Einheit (18) im Bereich einer Ladestation (8)/einer nachgeschalteten Rechnereinheit in Wirkverbindung steht.

## Claims

1. A method for the identification and quality documentation of accumulators (1) which can be used for industrial tools, in that the respective accumulator (1) is equipped with at least one electronic circuit (4) such that at least one component (9) of the circuit (4) is connected to the respective cell (2) of the accumulator (1), pre-determinable master data are written into a memory component (10) of the electronic circuit (4) during the first implementation or the manufacture of the accumulator (1) and in the course of further charging operations and/or repair works of the accumulator (1) the memory component (10) is written with at least operational data which have been determined in the course of the respective charging cycle or repair operation.

2. A method according to claim 1, **characterized in that** the master data are read from the memory component (10) in the course of a charging cycle or a repair operation, wherein after the charging operation or the repair work of the accumulator (1), at least operational data which have been determined in the course of the charging or repair operation are written in the memory component (10).

3. A method according to claim 1 or claim 2, **characterized in that** the respective data (D) are read from the memory component (10) of the electronic circuit (4) via lines/terminals (6, 7) which are provided in the area of the accumulator (1) and are also written in the memory component (10) via said lines/terminals (6, 7).

4. A method according to one of the claims 1 through 3, **characterized in that** the data (D) are read from the memory component (10) via the plus (6) and minus (7) lines of the accumulator (1) and are also written in the memory component (10) via said lines.

5. A method according to one of the claims 1 through 3, **characterized in that** the data (D) are read from the memory component (10) via the line of a temperature sensor (15) and the minus line (7) of the accumulator (1) and are also written in the memory component (10) via said lines.

6. A method according to one of the claims 1 through 5, **characterized in that** the data (D) are read from the memory component (10) via the charging set (8) of the accumulator (1) and/or a computer unit and are also written in the memory component (10) via said devices.

7. A method according to one of the claims 1 through 6, **characterized in that** the respective data (D) are read from the memory component (10) respectively written in this one in an encoded form.

8. A method according to one of the claims 1 through 7, **characterized in that** the respective charging/discharging operation of the accumulator (1) is documented over the time in the form of data and memorized in the memory component (10).

9. A method according to one of the claims 1 through 8, **characterized in that** the charging/discharging operation is documented in form of a graphic curve which can be displayed, in case of need, on a display (17) of the charging station (8).

10. A method according to one of the claims 1 through 9, **characterized in that** the charging station (8) of the accumulator (1) is connected to a computer unit, wherein all relevant data (D) are read from the memory component (10), if required, are output via the charging set (8) and transmitted to the computer unit as well as, in reverse order, written again in the memory component (10) after accomplished charging operation or accomplished repair works of the accumulator (1), such that each accumulator (1) is always equipped with its entire history, seen over the endurance thereof.

11. A method according to one of the claims 1 through 10, **characterized in that** a serial number which is allocated to the accumulator (1) is dropped into the memory component (10), via which serial number the accumulator (1) which is equipped with the electronic circuit (4) can be unequivocally identified.

12. A method according to one of the claims 1 through 10, **characterized in that** for simultaneously charging different accumulators (1) these ones are inserted into suitable adapters (22, 23, 24, 25) and are simultaneously checked and charged in a common charging station (20).

13. A method according to one of the claims 1 through 12, **characterized in that** electronic assembly units are provided in the area of the adapters (22 through 25) and connected to each other via a data bus line, wherein an individual data line is established from the charging station (20) to the computer unit.

14. A method according to one of the claims 1 through 13, **characterized in that** the computer unit includes a data base, in which the master data and the respective operational data of each accumulator (1) to be checked/charged are memorized.

15. A method according to one of the claims 1 through 14, **characterized in that** the data (D) of the respective current conduction (6, 7) of the accumulator (1) are modulated.

16. A method according to one of the claims 1 through 14, **characterized in that** the current supply of the accumulator (1) is interrupted in pre-determinable time intervals and during this period the respective data (D) are transmitted as packets in order to read/write the data (D).

17. An accumulator for industrial tools which is equipped with at least one electronic circuit (4) comprising at least one memory component (10) such that the electronic circuit (4) is connected to the respective cell (2) of the accumulator (1) within the housing (3) of the accumulator.

18. An accumulator according to claim 17, **characterized in that** the electronic circuit (4) includes at least one measuring electronics (9), one memory component (10) and one transmitting-receiving unit (12).

19. An accumulator according to claim 17 or claim 18, **characterized in that** the electronic circuit (4) includes a real-time clock (11) with calendar.

20. An accumulator according to one of the claims 17 through 19, **characterized in that** the respective data (D) can be read from the memory component (10) or written in the memory component (10) via lines/terminals (6, 7) which are provided in the area of the accumulator (1).

21. An accumulator according to one of the claims 17 through 20, **characterized in that** the measuring electronics (9) which is a micro-controller is actively related to the respective cell (2) of the accumulator (1).

22. An accumulator according to one of the claims 17 through 21, **characterized in that** the transmitting-receiving unit (12) of the electronic circuit (4) is actively related to a unit (18) of the same kind in the area of a charging station (8)/a downstream computer unit.

## Revendications

1. Procédé d'identification et de documentation de qualité des accumulateurs (1) utilisables pour des outils d'industrie, dans lequel l'accumulateur respectif (1) est muni d'au moins un circuit électronique (4) de sorte qu'au moins un composant (9) du circuit (4) est raccordé à la cellule respective (2) de l'accumulateur (1), des données de base pré-déterminables sont écrites dans un composant de mémoire (10) du circuit électronique (4) pendant la première implémentation ou la fabrication de l'accumulateur (1) et au cours d'autres opérations de chargement et/ou des réparations des accumulateurs (1), au moins des données de fonctionnement, qui ont été déterminées au cours du cycle de chargement respectif ou de l'opération de réparation respective, sont écrites dans le composant de mémoire (10).

2. Procédé selon la revendication 1, **caractérisé en ce que** les données de base sont lues dans le composant de mémoire (10) au cours d'un cycle de chargement ou d'une opération de réparation et à la suite de l'opération de chargement ou de la réparation de l'accumulateur (1) au moins des données de fonctionnement, qui ont été déterminées au cours de l'opération de chargement ou de réparation, sont écrites dans le composant de mémoire (10).

3. Procédé selon la revendication 1 ou la revendication 2, **caractérisé en ce que** les données respectives (D) sont lues dans le composant de mémoire (10) du circuit électronique (4) via des lignes/bornes (6, 7) qui se trouvent au niveau de l'accumulateur (1) et sont aussi écrites dans le composant de mémoire (10) via ces lignes/bornes (6, 7).

4. Procédé selon l'une des revendications 1 à 3, **caractérisé en ce que** les données (D) sont lues dans le composant de mémoire (10) via les lignes plus (6) et minus (7) de l'accumulateur (1) et sont aussi écrites dans le composant de mémoire (10) via ces lignes.

5. Procédé selon l'une des revendications 1 à 3, **caractérisé en ce que** les données (D) sont lues dans le composant de mémoire (10) via la ligne d'un détecteur de température (15) et la ligne minus (7) de l'accumulateur (1) et sont aussi écrites dans le composant de mémoire (10) via ces lignes.

6. Procédé selon l'une des revendications 1 à 5, **caractérisé en ce que** les données (D) sont lues dans le composant de mémoire (10) via le groupe-chargeur (8) de l'accumulateur (1) et/ou une unité d'ordinateur et sont aussi écrites dans le composant de mémoire (10) via ces dispositifs.

7. Procédé selon l'une des revendications 1 à 6, **caractérisé en ce que** les données respectives (D) sont lues respectivement écrites dans le composant de mémoire (10) sous forme codée.

8. Procédé selon l'une des revendications 1 à 7, **caractérisé en ce que** l'action respective de chargement/déchargement de l'accumulateur (1) est documentée avec le temps sous forme de données et mémorisée dans le composant de mémoire (10).

9. Procédé selon l'une des revendications 1 à 8, **caractérisé en ce que** l'action de chargement/déchargement est documentée sous forme d'une courbe graphique qui peut être éventuellement affichée sur un écran de visualisation (17) de la station de recharge (8).

10. Procédé selon l'une des revendications 1 à 9, **caractérisé en ce que** la station de recharge (8) de l'accumulateur (1) est reliée à une unité d'ordinateur, à quoi toutes les données importantes (D) sont, en cas de besoin, lues dans le composant de mémoire (10), sorties par le groupe-chargeur (8) et transmises à l'unité d'ordinateur ainsi que réécrites en sens inverse dans le composant de mémoire (10) après avoir accompli l'action de chargement ou de réparation de l'accumulateur, de sorte que chaque accumulateur (1) est toujours muni de toute son histoire vue par rapport à sa durabilité.

11. Procédé selon l'une des revendications 1 à 10, **caractérisé en ce qu'**un numéro de série à attribuer à l'accumulateur (1) est déposé dans le composant de mémoire (10), le numéro de série identifiant de manière univoque l'accumulateur (1) équipé du circuit électronique (4).

12. Procédé selon l'une des revendications 1 à 10, **caractérisé en ce que** pour charger simultanément des accumulateurs (1) différents, ceux-ci sont introduits dans des adaptateurs appropriés (22, 23, 24, 25) et sont simultanément vérifiés et chargés au niveau d'une station de recharge (20) commune.

13. Procédé selon l'une des revendications 1 à 12, caractérisé sen ce que des ensembles électroniques sont prévus au niveau des adaptateurs (22 à 25) et sont reliés les uns aux autres par moyen d'une ligne de bus de données, à quoi une ligne de données individuelle est établie à partir de la station de recharge (20) jusqu'à l'unité d'ordinateur.

14. Procédé selon l'une des revendications 1 à 13, **caractérisé en ce que** l'unité d'ordinateur comprend une base de données au niveau de laquelle les données de base et les données de fonctionnement respectives de chaque accumulateur (1) à vérifier/à charger sont déposées.

15. Procédé selon l'une des revendications 1 à 14, **caractérisé en ce que** les données (D) de la conduction de courant respective (6, 7) de l'accumulateur (1) sont modulées.

16. Procédé selon l'une des revendications 1 à 14, **caractérisé en ce que** l'alimentation en courant de l'accumulateur (1) est coupée dans des intervalles de temps pré-déterminables et pendant cette période les données (D) respectives sont transmises sous forme de paquets pour lire/écrire les données (D).

17. Accumulateur pour des outils d'industrie, qui est muni d'au moins un circuit électronique (4) comprenant un composant de mémoire (10) de sorte que le circuit électronique (4) est raccordé à la cellule respective (2) de l'accumulateur (1) à l'intérieur du boîtier d'accumulateur (3).

18. Accumulateur selon la revendication 17, **caractérisé en ce que** le circuit électronique (4) comprend au moins une électronique de mesure (9), un composant de mémoire (10) et une unité émission-réception (12).

19. Accumulateur selon la revendication 17 ou la revendication 18, **caractérisé en ce que** le circuit électronique (4) comprend une horloge temps-réel (11) avec calendrier.

20. Accumulateur selon l'une des revendications 17 à 19, **caractérisé en ce que** les données respectives (D) sont susceptibles d'être lues ou écrites dans le composant de mémoire (10) via des lignes/bornes (6, 7) qui se trouvent au niveau de l'accumulateur (1).

21. Accumulateur selon l'une des revendications 17 à 20, **caractérisé en ce que** l'électronique de mesure (9) qui est un microcontrôleur est activement reliée à la cellule respective (2) de l'accumulateur (1).

22. Accumulateur selon l'une des revendications 17 à 21, **caractérisé en ce que** l'unité émission-réception (12) du circuit électronique (4) est activement reliée à une unité du même genre (18) au niveau d'une station de recharge (8)/d'une unité d'ordinateur placée en aval.
